Europäisches Patentamt

European Patent Office

Office européen des brevets

(19)

(11) Numéro de publication: **0 143 680**
**B1**

(12) # FASCICULE DE BREVET EUROPEEN

(45) Date de publication du fascicule du brevet:
**24.06.87**

(51) Int. Cl.⁴: **H 03 H 9/05,** H 03 H 9/19,
G 04 F 5/06

(21) Numéro de dépôt: **84401917.4**

(22) Date de dépôt: **26.09.84**

(54) Résonateur piézo électrique pour environnement sévère.

(30) Priorité: **30.09.83 FR 8315654**

(43) Date de publication de la demande:
**05.06.85 Bulletin 85/23**

(45) Mention de la délivrance du brevet:
**24.06.87 Bulletin 87/26**

(84) Etats contractants désignés:
**BE CH DE GB IT LI LU NL SE**

(56) Documents cités:
**FR - A - 2 415 914**
**US - A - 3 263 103**
**US - A - 4 375 604**

(73) Titulaire: **COMPAGNIE D'ELECTRONIQUE ET DE
PIEZO-ELECTRICITE - C.E.P.E., 44, rue de la Glacière,
F-95100 Argenteuil (FR)**

(72) Inventeur: **Debaisieux, André, THOMSON-CSF
SCPI 173, bld Haussmann, F-75379 Paris Cedex 08 (FR)**
Inventeur: **Aubry, Jean-Pierre, THOMSON-CSF
SCPI 173, bld Haussmann, F-75379 Paris Cedex 08 (FR)**
Inventeur: **Michel, Luc, THOMSON-CSF SCPI 173, bld
Haussmann, F-75379 Paris Cedex 08 (FR)**

(74) Mandataire: **Ruellan-Lemonnier, Brigitte et al,
THOMSON-CSF SCPI 19, avenue de Messine,
F-75008 Paris (FR)**

ACTORUM AG

## Description

La présente invention concerne un résonateur piézo-électrique pour environnement sévère, comportant une embase munie de poteaux de maintien d'une lame piézo-électrique revêtue d'une électrode adhérente sur chacune de ses faces, chaque électrode étant électriquement reliée à un poteau conducteur, traversant l'embase, isolé de celle-ci. Un tel résonateur est connu du document US-A-4 375 604.

Les résonateurs piézo-électriques sont utilisés dans les oscillateurs constituant les bases de temps de très nombreux systèmes. Compte tenu des techniques actuelles de plus en plus sophistiquées, il est nécessaire d'assurer à ces bases de temps une variation de fréquence en particulier à court terme aussi faible que possible quelles que soient les conditions auxquelles ledit résonateur est soumis. Si certains paramètres comme les variations de température de l'environnement peuvent être compensées au niveau du circuit dans lequel est placé le résonateur lui-même, d'autres paramètres tels que par exemple la tenue aux accélérations et la résistance aux vibrations ne peuvent être améliorées qu'en modifiant le comportement du résonateur lui-même. A l'heure actuelle, de nombreuses études sont menées pour améliorer la tenue aux vibrations et en particulier aux ondes de choc électro-nucléaires, des différents composants électroniques et notamment des résonateurs piézo-electriques. L'amélioration de la tenue aux vibrations des résonateurs piézo-électriques se caractérise par la recherche de l'augmentation de la fréquence de résonance mécanique de la monture quartz et embase, c'est-à-dire en particulier l'amélioration du spectre de bruit au voisinage de la porteuse du pilote utilisant cette monture. On s'est rendu compte qu'un résonateur à quartz constitué d'une lame piézo-électrique circulaire comportant une électrode métallisée sur chacune des ses faces et fixée sur une embase entre des poteaux de maintien éventuellement conducteurs, avait une tenue aux vibrations relativement médiocre. Les vibrations extérieures auxquelles la monture est soumise sont transmises à la lame piézo-électrique par l'embase et les poteaux de fixation de ladite lame sur celle-ci. Ceci induit, semble-t-il, des ondes de surface sur la lame de quartz se traduisant par l'apparition de pics au voisinage de la porteuse, pics d'amplitude importante nuisant fortement à la pureté spectrale de l'oscillateur utilisant cette lame.

L'invention permet d'améliorer la tenue aux vibrations des résonateurs piézo-électriques et d'abaisser ou de supprimer les pics résultant des vibrations mécaniques de la monture. Le résonateur selon l'invention est caractérisé en ce que la lame de matériau piézo-électrique est d'un seul tenant et présente une zone active centrale qui est le siège des ondes de volume du résonateur, entourée par une couronne périphérique reliée à ladite partie centrale par $2n$ ponts, avec $n$ entier, supérieur ou égal à 2, deux ponts de largeur $L_2$ étant situés sensiblement sur l'axe ZZ' de la lame piézo-électrique, les autres ponts, de largeur $L_1$ inférieure à $L_2$, étant disposés symétriquement par rapport audit axe ZZ', lesdits ponts définissant entre la zone active et la couronne périphérique une pluralité de fentes, ladite lame piézo-électrique étant fixée par sa couronne périphérique aux poteaux de maintien.

De préférence, le résonateur selon l'invention ne comportera que deux ponts de largeur $L_1$, disposés sensiblement sur l'axe XX', perpendiculaire à l'axe ZZ'. (Ces axes sont les axes de référence habituels, bien connu de l'homme de métier, selon la coupe cristallographique utilisée pour réaliser la lame piézo-électrique).

Selon un mode préférentiel de réalisation de l'invention, le rapport $L_2/L_1$ sera compris entre sensiblement 2 et 4.

On a en effet constaté qu'une lame de quartz piézo-électrique réalisée de la manière ci-dessus permettait d'améliorer très sensiblement, ainsi qu'on le verra par la suite à la lecture des résultats de mesures, la tenue aux vibrations de celle-ci. On a en effet constaté de manière inattendue que l'on devait réaliser un découplage mécanique entre la zone active centrale de la lame piézo-électrique et la partie périphérique à laquelle sont fixés les poteaux de maintien et/ou poteaux conducteurs, pour améliorer la tenue aux vibrations du résonateur. Mais les ponts de matériaux piézo-électriques reliant ces deux zones doivent être disposés de manière particulière et avoir des dimensions également très particulières. Les meilleurs résultats sont obtenus avec deux ponts situés sur l'axe ZZ' de la lame, deux ponts de largeur relativement importante $L_2$, assurant le maintien des deux zones entre elles dans une partie de la lame où le module d'Young du matériau est le plus faible (sensiblement de part et d'autre de l'axe ZZ'). La Demanderesse pense qu'ainsi, on limite la transmission des contraintes de la zone périphérique à la zone active. En pratique, on constate toutefois, une amélioration notable en réalisant également des fixations par ponts en d'autres points de la lame piézo-électrique. Toutefois, et afin de limiter la transmission des contraintes d'une zone à l'autre, on a constaté que ces ponts «secondaires» de préférence au nombre de deux seulement et situés symétriquement par rapport à l'axe ZZ', devaient être de largeur $L_1$ plus faible que celle des ponts principaux situés sur l'axe ZZ'. D'une manière générale, le rapport $L_2/L_1$ variera de préférence entre 2 et 4, par des quartz de coupe SC, ou voisine de celle-ci. En pratique, on obtient de bons résultats pour un quartz 10 MHZ de coupe SC avec des ponts principaux d'une largeur de l'ordre de 2,5 millimètres tandis que les ponts latéraux (ou secondaires) sur l'axe XX' ont une largeur de l'ordre de 0,8 millimètre. Il est possible d'utiliser plusieurs ponts secondaires de largeur $L_1$ en respectant la symètrie de l'ensemble. Toutefois, les meilleurs résultats sont également obtenus lorsque ces ponts sont le plus proche possible de l'axe XX'. On constate que dans les configurations décrites ci-dessus, la monture quartz+embase se révèle de manière inattendue excellente en tenue aux vibrations, bien que sa variation de fréquence $\Delta f/f$ soit moins bonne que dans d'autres configurations. Pour plus de détail sur ces configurations, on pourra se reporter à la demande française déposée simultanément par la Demanderesse sous le titre «Résonateur piézo-électrique de faible sensibilité aux accélérations» et incorporé dans cette demande à titre de référence.

L'invention sera mieux comprise à l'aide des exemples de réalisation suivants, donnés à titre non limitatif, conjointement avec les figures qui représentent:

La fig. 1 une vue de dessus d'une lame piézo-électrique selon l'invention,

la fig. 2 une vue de dessus d'une variante d'une lame piézo-électrique selon l'invention,

la fig. 3 une vue d'une lame piézo-électrique selon l'invention et de son embase.

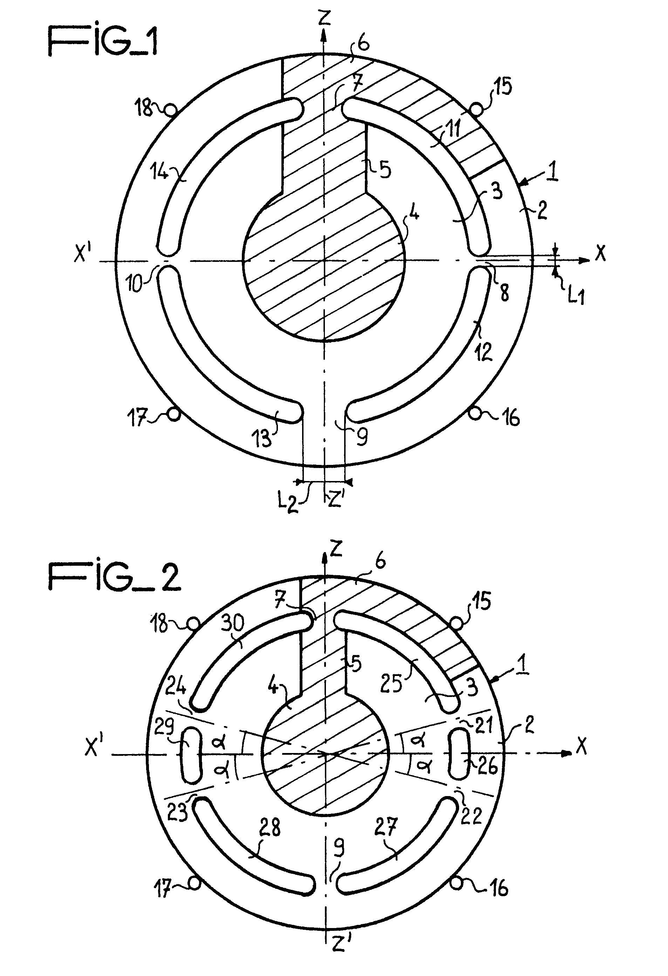

Sur la fig. 1, est représentée la variante préférentielle de réalisation de la lame piézo-électrique selon l'invention. Cette lame piézo-électrique 1 comporte une couronne périphérique 2 reliée à une zone active 3 par quatre ponts 7, 8, 9 et 10. Les ponts 7 et 9, situés sur l'axe ZZ' de la lame, ont une largeur $L_2$, tandis que les ponts 8 et 10 situés sur l'axe XX' de la lame ont une largeur $L_1$ inférieur à $L_2$. Ces ponts 7, 8, 9 et 10 sont respectivement séparés par des fentes 11, 12, 13 et 14, fentes s'étendant de part en part à travers la lame de matériau piézo-électrique. La zone active de la lame (déterminée de manière empirique par l'homme de métier par mesure des ondes de volume au sein du quartz) comporte sur sa partie centrale une électrode adhérente métallisée 4 reliée par une zone de prolongement métallisée 5 à une zone métallisée 6 sur la couronne phéripherique 2, et traversant le pont 7. Cette zone métallisée 6 est reliée au poteau conducteur de maintien 15. Une seconde électrode, non représentée sur la figure, disposée sur la face inférieure de la lame et présentant la même disposition géométrique, traverse le pont 9 et vient au contact du poteau conducteur et de maintien 17 par une zone métallisée. Les poteaux 16 et 18 ont uniquement une fonction de maintien mécanique de la lame. Ces différents poteaux qui ont une fonction de maintien de la lame, seront disposés sensiblement à mi-distance entre deux ponts successifs. Leur nombre sera variable en fonction des résultats désirés: dans l'exemple présent, quatre poteaux de maintien, dont deux poteaux conducteurs 15, 17, se sont avérés donner les meilleurs résultats.

La fig. 2 est une variante de réalisation de la fig. 1 sur laquelle les mêmes éléments portent les mêmes références. Les ponts principaux 7 et 9 de largeur $L_2$, ont été maintenus tandis que quatre ponts de faible largeur $L_1$ ont été utilisés de part et d'autre de l'axe ZZ', disposés de manière symétrique et formant un angle avec l'axe XX'. Ces ponts, respectivement 21, 22, 23 et 24 délimitent entre eux et avec les ponts 7 et 9 des fentes 25, 26, 27, 28, 29 et 30. Comme dans l'exemple précédent, ces fentes ont une largeur adaptée aux résultats que l'on désire obtenir c'est-à-dire limiter la transmisssion des chocs par l'intermédiaire du poteau de maintien à la zone active 3 de la lame. En pratique, on constate que des fentes de largeur de l'ordre de 1 mm, obtenues par exemple par voie chimique ou par voie ultrasonique, donnent d'excellents résultats. Les poteaux conducteurs et/ou de maintien dans cette variante de la fig. 2 sont également au nombre de quatre et sont disposés de manière à respecter la symétrie de l'ensemble, c'est-à-dire sensiblement équidistants des deux ponts les plus proches. Dans le cas présent, on aurait pu envisager d'ajouter deux poteaux de maintien supplémentaires disposés sensiblement sur l'axe XX'.

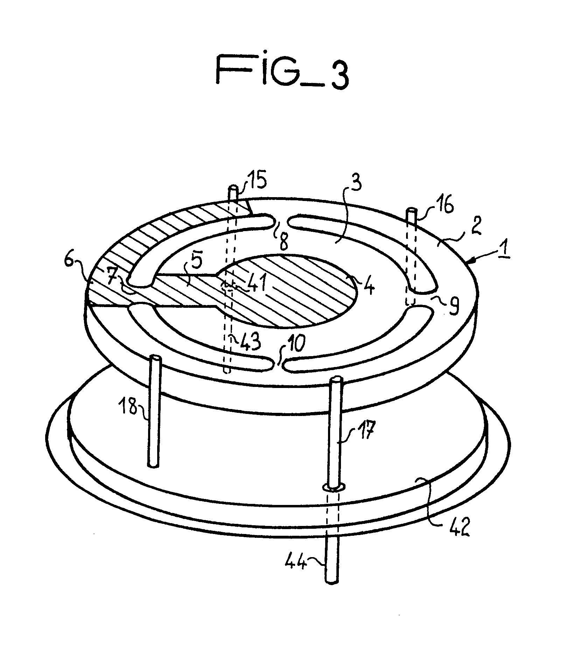

La fig. 3 représente une vue d'une lame selon l'invention fixée sur son embase, figure sur laquelle les mêmes éléments que ceux des figures précédentes portent les mêmes références. La lame est celle représentée schématiquement sur la fig. 1. Les poteaux électriquement conducteurs ayant également une fonction de maintien 15 et 17 traversent l'embase 42 à travers respectivement une perle de verre isolante 41, 40 et se prolongent extérieurement par des poteaux conducteurs 43 et 44 destinés à être reliés aux circuits d'utilisation. Les deux ponts de maintien 16 et 18 sont solidaires de l'embase 42 sans isolation électrique.

D'une manière générale, on a constaté que les meilleurs résultats étaient obtenus en utilisant des poteaux de maintien fixés en des zones dans lesquelles le module d'Young de la lame était sensiblement identique, à plus ou moins 20%.

*Exemples comparatifs*

On prend un quartz 10 MHZ de coupe SC constitué par une lame de 15 mm de diamètre ayant une face convexe de rayon RC = 300 mm dont les métallisations d'électrodes ont un diamètre de 5,5 mm. Cette lame est fixée aux deux poteaux d'une embase selon l'axe ZZ'. Cette monture ainsi réalisée est montée dans un oscillateur pilote et soumise à des tests de vibrations à différentes fréquences. On regarde alors les spectres de bruit au voisinage de la porteuse. On constate deux pics importants aux environs de 6 et 7 KHZ, de part et d'autre de celle-ci.

En utilisant la même monture munie d'un quartz comportant une découpe de 1 mm de largeur et 4 ponts, deux de largeur 25/10 mm sur l'axe ZZ', deux de largeur 8/10 mm sur l'axe XX' et deux poteaux de maintien et de connexion électrique à mi-distance de deux ponts successifs, on constate alors que les pics précédents ont disparu, leur amplitude étant ramenée environ 20 dB en dessous de leur niveau précédent.

**Revendications**

1. Résonateur piézo-électrique pour environnement sévère comportant une embase (42) munie de poteaux de maintien (15, 16, 17, 18) d'une lame piézo-électrique (1) revêtue d'une électrode adhérente (4), sur chacune de ses faces, chaque électrode (4) étant électriquement reliée à un poteau conducteur (15, 17), traversant l'embase (42), électriquement isolé de celle-ci, caractérisé en ce que la lame de matériau piézo-électrique (1) est d'un seul tenant et présente une zone active centrale (3) qui est le siège des ondes de volume du résonateur, entourée par une couronne périphérique (2) reliée à ladite partie centrale par 2n ponts (7, 8, 9, 10), avec n entier, supérieur ou égal à 2, deux ponts (7, 9) de largeur $L_2$ étant situés sensiblement sur l'axe ZZ' de la lame piézo-électrique (1), les autres ponts (8, 10), de largeur $L_1$ inférieure à $L_2$ étant disposés symétriquement par rapport audit axe ZZ', lesdits ponts (7, 8, 9, 10) définissant entre la zone active (3) et la couronne périphérique (2) une pluralité de fentes (11-14, 25-30), ladite lame piézo-électrique (1) étant fixée par sa couronne périphérique aux poteaux de maintien (15, 16, 17, 18).

2. Résonateur piézo-électrique pour environnement sévère selon la revendication 1, caractérisé en ce que le résonateur ne comporte que deux ponts (8, 10) de largeur $L_1$, disposés sensiblement sur l'axe XX', perpendiculaire à l'axe ZZ'.

3. Résonateur piézo-électrique pour environnement sévère selon l'une des revendications 1 ou 2, caractérisé en ce que:

$$2 \leqslant L_2/L_1 \leqslant 4$$

4. Résonateur piézo-électrique pour environnement sévère selon l'une des revendications 1 à 3, caractérisé en ce qu'il comporte une lame de quartz (1) de coupe SC ou voisine de celle-ci.

## Patentansprüche

1. Kristallresonator für strenge Umweltbedingungen, bestehend aus einem Sockel (42), versehen mit Stützen (15, 16, 17, 18) für eine piezoelektrische Platte (1), überzogen auf jeder Plattenseite mit einer festhaftenden Elektrode (4), welche jeweils elektrisch mit einer leitfähigen, den Sockel (42) durchquerenden und von diesem elektrisch isolierten Stütze (15, 17) verbunden ist, dadurch gekennzeichnet, dass die Platte aus piezoelektrischem Material (1) in einem Stück gefertigt ist und einen zentralen Wirkungsbereich (3) aufweist, in der sich die Resonatormengenwellen befinden, umgeben von einem Aussenkranz (2), der mit dem genannten zentralen Teil durch 2n Brücken (7, 8, 9, 10) verbunden ist, wobei die ganze Zahl n grösser oder gleich 2 ist, wobei sich zwei Brücken (7, 9) mit Breite $L_2$ etwa in der Achse ZZ' der piezoelektrischen Platte (1) befinden, während die anderen Brücken (8, 10) mit Breite $L_1$ niedriger als $L_2$ im Verhältnis zur genannten Achse ZZ' symmetrisch angeordnet sind, wobei die genannten Brücken (7, 8, 9, 10) zwischen dem Wirkungsbereich (3) und dem Aussenkranz (2) eine Vielzahl von Schlitzen (11-14, 25-30 bestimmen, wobei die piezoelektrische Platte durch ihren Aussenkranz an den Stützen (15, 16, 17, 18) befestigt ist.

2. Kristallresonator für strenge Umweltbedingungen nach Anspruch 1, dadurch gekennzeichnet, dass der Resonator nur zwei Brücken (8, 10) mit Breite $L_1$ besitzt, die senkrecht zur Achse ZZ' etwa in der Achse XX' angeordnet sind.

3. Kristallresonator für strenge Umweltbedingungen nach Anspruch 1 oder 2, dadurch gekennzeichnet dass

$$2 \leqslant L_2/L_1 \leqslant 4$$

ist.

4. Kristallresonator für strenge Umweltbedingungen nach einem der Ansprüche 1 bis 3, dadurch gekennzeichnet, dass er eine Platte aus Quarz (1) mit SC-Schnitt oder mit ähnlichem Schnitt besitzt.

## Claims

1. Piezoelectric resonator for severe environment including one base (42) equipped with posts (15, 16, 17, 18) supporting piezoelectric slab (1) covered with an adherent electrode (4) on each side, each electrode (4) being connected electrically to a conductive post (15, 17) passing through base (42), electrically isolated from it, wherein the sheet of piezoelectric material (1) is a single piece exhibiting a central active zone (3) which is the seat of the body wave of the resonator, surrounded by a peripheral crown (2) connected to the said central part by 2 n bridges (7, 8, 9, 10), where n is an integer greater than or equal to two, of which two bridge (7, 9) of width $L_2$ are located roughly along the ZZ' axis of the piezoelectric sheet (1), while the other bridges (8, 10), of width $L_1$, less than $L_2$, are arranged symmetrically about the said ZZ' axis, the said bridges (7, 8, 9, 10) defining between the active zone (3) and the peripheral crown (2) a plurality of slots (11-14, 25-30), the said piezoelectric slab (1) being fastened by its peripheral crown to support posts (15, 16, 17, 18).

2. Piezoelectric resonator for severe environment as claimed in claim 1, wherein the resonator includes only two bridges (8, 10) of width $L_1$, arranged roughly along the line XX' perpendicular to the ZZ' axis.

3. Piezoelectric resonator for severe environment as claimed in either claim 1 or 2, wherein:

$$2 \leqslant L_2/L_1 \leqslant 4$$

4. Piezoelectric resonator for severe environment as claimed in any claim 1 to 3, wherein it includes one SC-out quartz slab or a similarly cut slab.

FIG_1

FIG_2

0 143 680

# FiG_3